(19) Europäisches Patentamt
European Patent Office
Office européen des brevets

(11) **EP 3 232 206 B1**

(12) **EUROPÄISCHE PATENTSCHRIFT**

(45) Veröffentlichungstag und Bekanntmachung des Hinweises auf die Patenterteilung:
**16.02.2022 Patentblatt 2022/07**

(21) Anmeldenummer: **17161788.9**

(22) Anmeldetag: **20.03.2017**

(51) Internationale Patentklassifikation (IPC):
**G01R 15/22** *(2006.01)* **G01R 15/24** *(2006.01)*

(52) Gemeinsame Patentklassifikation (CPC):
**G01R 15/22; G01R 15/245**

(54) **SENSORELEMENT, SENSORVORRICHTUNG UND VERFAHREN ZUM DETEKTIEREN VON ZUMINDEST EINER ELEKTRISCHEN LEITUNG**

SENSOR ELEMENT, SENSOR DEVICE AND METHOD FOR DETECTING AT LEAST ONE ELECTRIC LINE

ÉLÉMENT CAPTEUR, DÉTECTEUR ET PROCÉDÉ DE DÉTECTION D'AU MOINS UNE CONDUITE ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.04.2016 DE 102016205980**

(43) Veröffentlichungstag der Anmeldung:
**18.10.2017 Patentblatt 2017/42**

(73) Patentinhaber: **Robert Bosch GmbH
70442 Stuttgart (DE)**

(72) Erfinder:
• **Lutz, Theresa
85521 Ottobrunn (DE)**
• **Purkl, Fabian
71277 Rutesheim (DE)**
• **Krayl, Oliver
70839 Gerlingen (DE)**
• **Roelver, Robert
75365 Calw-Stammheim (DE)**

(56) Entgegenhaltungen:
**WO-A1-2013/188732 US-A1- 2015 374 250**

EP 3 232 206 B1

## Beschreibung

Stand der Technik

Der Ansatz geht aus von einer Vorrichtung oder einem Verfahren nach Gattung der unabhängigen Ansprüche.

Ein präzises Messen eines Verlaufs von elektrischen Leitungen und der darin fließenden Stromstärke ist für viele Anwendungen von großer Bedeutung, wie z. B. für die Fehlersuche in elektrischen Anlagen oder das Auffinden des Verlaufs von elektrischen Leitungen in Wänden. Als bisherige Lösungen zum Aufspüren spannungsführender elektrischer Leitungen existieren vor allem Leitungssucher basierend auf kapazitiven Messprinzipien.

Die DE 873 706 B beschreibt eine Anordnung zur Auslösung elektrischer Signale oder Impulse, insbesondere zur Achszählung schienengebundener Fahrzeuge.

Die WO 2013/188732 A1 offenbart ein System zum optischen Abbilden elektrischer Ströme unter Verwendung von Stickstoff-Vakanz-Zentren.

Die US 2015/374250 A1 offenbart eine Messanordnung zum hochgenauen erfassen eines Magnetfelds unter Verwendung von Stickstoff-Vakanz-Paaren.

Offenbarung der Erfindung

Vor diesem Hintergrund wird mit dem hier vorgestellten Ansatz eine Sensorvorrichtung zum Detektieren von zumindest einer elektrischen Leitung gemäß dem Hauptanspruch vorgestellt. Durch die in den abhängigen Ansprüchen aufgeführten Maßnahmen sind vorteilhafte Weiterbildungen und Verbesserungen der im unabhängigen Anspruch angegebenen Vorrichtung möglich.

Ein Sensorelement zum Detektieren einer elektrischen Leitung weist die folgenden Merkmale auf:

eine Diamantschicht mit zumindest einem Stickstoff-Vakanz-Zentrum, wobei eine Fluoreszenzeigenschaft der Diamantschicht abhängig von einem durch einen durch die elektrische Leitung fließenden Strom hervorrufbaren Magnetfeld ist; und

eine Detektionseinrichtung zum Detektieren einer Fluoreszenz der Diamantschicht und zum Bereitstellen eines von der Fluoreszenz abhängigen Detektionssignals. Die Detektionseinrichtung kann hierbei eine Photodiode wie eine Silizium-Photodiode sein. Das Detektionssignal kann eine Charakteristik oder einen Wert der Fluoreszenz repräsentieren. Da die Fluoreszenz der Diamantschicht abhängig von dem auf die Diamantschicht einwirkenden Magnetfeld ist, kann das Detektionssignal einen Wert des Magnetfelds, beispielsweise einen Betrag und/oder eine Richtung des Magnetfelds, repräsentieren oder zur Bestimmung eines solchen Werts verwendet werden.

Ein mit dem vorgestellten Ansatz erreichbarer Vorteil ist, dass durch ein Sensorelement eine elektrische Leitung sowohl detektiert, als auch eine Stromstärke eines durch die elektrische Leitung fließenden Stroms einfach und schnell bestimmt werden kann.

Von Vorteil kann es dabei sein, wenn das Sensorelement zumindest eine Bestrahlungseinrichtung zum Bestrahlen der Diamantschicht mit einer elektromagnetischen Strahlung aufweist. Durch die elektromagnetische Strahlung kann die Diamantschicht gezielt zur Emission von Licht in Form der Fluoreszenz angeregt werden.

Die Bestrahlungseinrichtung kann beispielsweise dazu ausgebildet sein, Mikrowellenstrahlung als die elektromagnetische Strahlung auszusenden. Hierzu kann die Bestrahlungseinrichtung eine Antenne wie eine RF-Streifenantenne zum Aussenden von Mikrowellenstrahlung aufweisen. Die elektromagnetische Strahlung in Form von Mikrowellenstrahlung kann die Fluoreszenz der Diamantschicht anregen.

Die Bestrahlungseinrichtung kann gemäß einer Ausführungsform zusätzlich oder alternativ dazu ausgebildet sein, Licht als die elektromagnetische Strahlung auszusenden. Hierbei kann die Bestrahlungseinrichtung eine Lichtquelle sein, die beispielsweise zumindest einen Leuchtdioden-Laserchip, also einen LED-Laserchip, und/oder einen Oberflächenemitter, wie einen VCSEL-Laserchip, aufweist. Die elektromagnetische Strahlung in Form von Licht kann ebenfalls die Fluoreszenz der Diamantschicht anregen.

Um einen die Diamantschicht durchdringenden Anteil der elektromagnetischen Strahlung auszufiltern, kann das Sensorelement eine Filtereinrichtung aufweisen. Die Filtereinrichtung kann beispielsweise einen optischen Filter zum Filtern des Lichts aufweisen. Die Filtereinrichtung kann vorteilhafterweise zwischen der Diamantschicht und der Detektionseinrichtung angeordnet sein, um das durch die Diamantschicht durchgedrungene Licht vor einem Auftreffen auf die Detektionseinrichtung zu filtern. Auf diese Weise kann verhindert werden, dass die elektromagnetische Strahlung von der Detektionseinrichtung detektiert wird.

Eine Sensorvorrichtung weist eine Auflagefläche zum Auflegen der Sensorvorrichtung auf eine Fläche und zumindest ein benachbart zu der Auflagefläche angeordnetes Sensorelement auf. Die Fläche kann eine Wand und/oder jede beliebige Fläche sein, hinter der eine elektrische Leitung angeordnet ist oder vermutet wird. Die Auflagefläche kann eine Rückseite einer Trägerschicht des Sensorelements sein oder beispielsweise eine Wandfläche einer Wand eines das Sensorelement beinhaltenden Gehäuses der Sensorvorrichtung darstellen.

Um eine Mehrzahl von weiteren Detektionssignalen, die beispielsweise einen Verlauf der Leitung repräsentieren können, bereitstellen zu können, kann die Sensorvorrichtung mehrere Sensorelemente aufweisen. Die Sensorelemente können sich dabei gemäß einer Ausführungsform über die gesamte Auflagefläche der Sensorvorrichtung erstrecken. Dabei kann die Sensorvorrichtung vorteilhafterweise eine handliche Größe von im Wesentlichen $10 \times 20 \times 1$ cm$^3$ aufweisen. Um eine Mehrzahl von Sensorelementen in der Sensorvorrichtung anordnen zu können, kann ein einzelnes etwa eine Größe von $1 \times 1 \times 0{,}5$ cm$^3$ aufweisen.

Beispielsweise kann die Sensorvorrichtung ein Feld aus einer Mehrzahl von nebeneinander und benachbart zu der Auflagefläche angeordneten Sensorelementen aufweisen. Durch das Feld kann ein sogenanntes Sensorarray ausgeformt werden. Die Sensorelemente können in einer Ebene angeordnet sein, die sich parallel zu der Auflagefläche erstrecken kann. Die Mehrzahl von Sensorelementen erleichtert zum einen das Auffinden einer Leitung. Ferner kann ein Verlauf der Leitung erkannt werden.

Gemäß einer Ausführungsform kann die Sensorvorrichtung zumindest einen Stapel aus zumindest zwei Sensorelementen aufweisen, die im Wesentlichen vertikal zu der Auflagefläche benachbart zueinander angeordnet sind. Die Detektionssignale der zwei übereinandergestapelten Sensorelemente können zur Bestimmung einer Stromstärke des das Magnetfeld hervorrufenden Stroms und zusätzlich oder alternativ zur Bestimmung eines Abstands zwischen der Auflagefläche und der den Strom führenden Leitung verwendet werden.

Die Sensorvorrichtung kann eine gemeinsame Bestrahlungseinrichtung zum gemeinsamen Bestrahlen der Diamantschichten der Mehrzahl von Sensorelementen mit einer elektromagnetischen Strahlung aufweisen. Auf diese Weise ist es nicht erforderlich, die Sensorelemente selbst mit Bestrahlungseinrichtungen zu versehen.

Die Sensorvorrichtung kann eine Auswerteeinrichtung aufweisen, die dazu ausgebildet ist, einen Wert eines Magnetfelds im Bereich des Sensorelements unter Verwendung des Detektionssignals zu bestimmen. Der Wert kann beispielsweise einen Betrag und/oder eine Richtung des Magnetfelds repräsentieren. Umfasst die Sensorvorrichtung mehrere Sensorelemente, die je ein Detektionssignal bereitstellen, so kann die Auswerteeinrichtung ausgebildet sein, um für jedes der Sensorelemente einen Wert des Magnetfelds im Bereich des jeweiligen Sensorelements unter Verwendung des jeweiligen Detektionssignals zu bestimmen. Auf diese Weise kann eine Charakteristik des Magnetfelds sehr genau bestimmt werden, wodurch wiederum sehr exakt auf eine oder mehrere das Magnetfeld hervorrufende stromdurchflossene Leitungen geschlossen werden kann.

Um eine beispielsweise zweidimensionale optische Darstellung der elektrischen Leitung zu ermöglichen, kann die Auswerteeinrichtung dazu ausgebildet sein, ein Bildsignal zur bildlichen Darstellung der elektrischen Leitung unter Verwendung des genannten Werts des Magnetfelds, z. B. in Abhängigkeit von einer Lage des Sensorelements, zu bestimmen. Zusammen mit weiteren Werten des Magnetfelds, die beispielsweise unter Verwendung weiterer Sensorelemente der Sensorvorrichtung bestimmt wurden, kann das Bildsignal einen zweidimensionalen Verlauf der Leitung anzeigen.

Die Sensorvorrichtung kann eine Einstelleinrichtung aufweisen, die ausgebildet ist, um einen vertikalen Abstand des Sensorelements zu der Auflagefläche einzustellen. Beispielsweise kann das Detektionssignal bestimmt werden, während sich das Sensorelement in einem ersten Abstand zu der Auflagefläche befindet, und ein weiteres Detektionssignal bestimmt werden, während sich das Sensorelement in einem zweiten Abstand zu der Auflagefläche befindet. Die unterschiedlichen Abstände können einfach unter Verwendung der Einstelleinrichtung eingestellt werden. Unter Verwendung der zwei Detektionssignale kann unter Verwendung bekannter physikalischer Zusammenhänge ein Abstand zwischen der Leitung und der Sensorvorrichtung sowie eine Stromstärke des durch die Leitung fließenden Stroms bestimmt werden..

Die Auswerteeinrichtung kann somit zur Bestimmung des Abstands zu der Leitung und/oder des durch die Leitung fließenden Stroms dazu ausgebildet sein, einen weiteren Wert des Magnetfelds an dem Sensorelement oder an einem weiteren Sensorelement unter Verwendung eines weiteren Detektionssignals zu bestimmen. Gemäß einer Ausführungsform wird somit ein Sensorelement zur Bereitstellung zweier Detektionssignale verwendet, wobei sich das Sensorelement während der Bereitstellung des ersten Detektionssignals an einer ersten Position und während der Bereitstellung des zweiten Detektionssignals an einer zweiten Position befindet. Die unterschiedlichen Positionen können beispielsweise unter Verwendung einer Einstelleinrichtung eingestellt werden oder unter Verwendung einer kombinierten Beschleunigungs- und Drehratensensoreinrichtung erfasst werden. Um die Rotation der Sensoreinrichtung zu erfassen, ist es weiterhin möglich, die Bestimmung der Winkelposition im Raum über eine Erdmagnetfeldmessung durchzuführen. Das konstante Erdmagnetfeld lässt sich aufgrund seiner positionsinvarianten und bekannten Stärke von ca. 40 μT relativ einfach aus den Sensordaten der NV-Diamantsensoreinheiten extrahieren.

Auf diese Weise ist nur ein Sensorelement zur Bestimmung eines Abstands zu der Leitung und des Stromflusses durch die Leitung erforderlich. Alternativ werden zwei Sensorelemente zur Bereitstellung der zwei Detektionssignale verwendet. Die zwei Sensorelemente können in einer übereinandergestapelt angeordnet sein. Diese ermöglicht eine gleichzeitige Erfassung der zwei Detektionssignale, wodurch die Durchführung der Messung vereinfacht werden kann.

Die Sensorvorrichtung kann auch eine Beschleunigungssensoreinrichtung und/oder Drehratensensoreinrichtung aufweisen, die ausgebildet ist, um eine Beschleunigung und/oder Rotation der Sensorvorrichtung zu erfassen und ein die Beschleunigung und/oder Rotation repräsentierendes Beschleunigungssignal auszugeben. Die Auswerteeinrichtung kann ferner dazu ausgebildet sein, um dem ersten Wert des Magnetfelds unter Verwendung des Beschleunigungssignals einen Positionswert zuzuordnen. Auf diese Weise können zu unterschiedlichen Zeitpunkten Detektionssignale von ein und demselben Detektionselement bereitgestellt werden, wobei unter Verwendung des Beschleunigungssignals festgestellt werden kann, wie sich die Position des Sensorelements zwischen der Bereitstellung zweier Detektionssignale verändert hat. Auf diese Weise kann das Magnetfeld unter Verwendung eines einzigen Sensorelements vermessen werden. Zusätzlich oder alternativ zu einer Drehratensensoreinrichtung kann die Sensorvorrichtung auch eine Bestimmungseinrichtung aufweisen, die ausgebildet ist, um eine Winkelpositionsänderung und somit eine Rotation der Sensorvorrichtung basierend auf Erdmagnetfeldmessungen zu erfassen. Entsprechend kann die Auswerteeinrichtung dazu ausgebildet sein, um dem ersten Wert des Magnetfelds den Positionswert zusätzlich oder alternativ unter Verwendung eines die Winkelpositionsänderung anzeigenden Winkelpositionsänderungssignals zuzuordnen.

Ein Verfahren zum Detektieren einer elektrischen Leitung ist dazu ausgebildet, die elektrische Leitung unter Verwendung einer Diamantschicht mit zumindest einem Stickstoff-Vakanz-Zentrum zu detektieren. Eine Fluoreszenzeigenschaft der Diamantschicht ist dabei abhängig von einem durch einen durch die elektrische Leitung fließenden Strom hervorrufbaren Magnetfeld. In einem Schritt des Detektierens wird eine Fluoreszenz der Diamantschicht detektiert. In einem Schritt des Bereitstellens wird ein die Fluoreszenz repräsentierendes Detektionssignal bereitgestellt.

Dieses Verfahren kann beispielsweise in Software oder Hardware oder in einer Mischform aus Software und Hardware beispielsweise in einem Steuergerät implementiert sein.

Ausführungsbeispiele des hier vorgestellten Ansatzes sind in den Zeichnungen dargestellt und in der nachfolgenden Beschreibung näher erläutert. Es zeigt:

    Fig. 1 eine schematische Darstellung einer elektrischen Leitung;
    Fig. 2 eine schematische Darstellung einer Sensorvorrichtung;
    Fig. 3 einen Querschnitt eines Sensorelements gemäß einem Ausführungsbeispiel;
    Fig. 4 einen Querschnitt einer Sensorvorrichtung gemäß einem Ausführungsbeispiel;
    Fig. 5 eine perspektivische Darstellung einer Sensorvorrichtung gemäß einem Ausführungsbeispiel;
    Fig. 6 einen Querschnitt einer Sensorvorrichtung gemäß einem Ausführungsbeispiel; und
    Fig. 7 ein Ablaufdiagramm eines Verfahrens zum Detektieren einer elektrischen Leitung.

In der nachfolgenden Beschreibung günstiger Ausführungsbeispiele des vorliegenden Ansatzes werden für die in den verschiedenen Figuren dargestellten und ähnlich wirkenden Elemente gleiche oder ähnliche Bezugzeichen verwendet, wobei auf eine wiederholte Beschreibung dieser Elemente verzichtet wird.

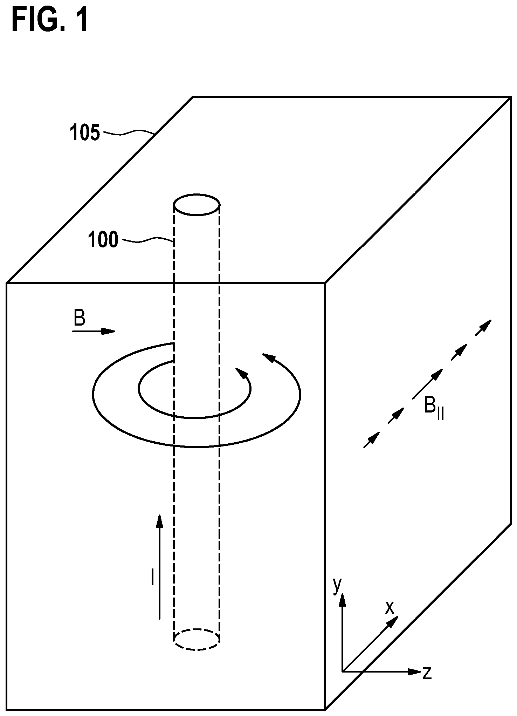

Fig. 1 zeigt eine schematische Darstellung einer elektrischen Leitung 100. Die elektrische Leitung 100 ist in einer Wand 105 angeordnet. Durch die Leitung 100 fließt ein Strom mit einer elektrischen Stromstärke I. Aufgrund des in der Leitung 100 fließenden Stroms wird ein Magnetfeld B erzeugt, das sich radial um die Leitung 100 erstreckt. Um die Stromstärke I zu berechnen, kann folgende Formel angewendet werden:

$$B = \mu \frac{I}{2\pi r}$$

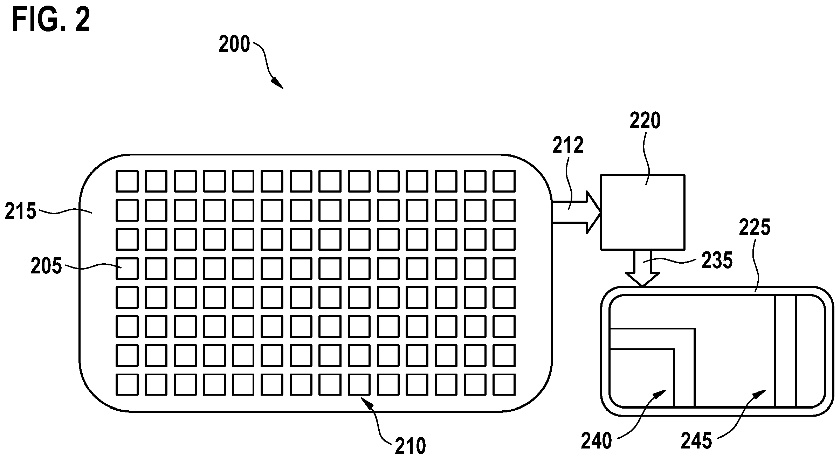

Dabei ist $\mu$ die magnetische Feldkonstante und r der Radius, der einen Abstand zwischen der Leitung 100 und einem Strommessgerät, wie der anhand von Fig. 2 beschriebenen Sensorvorrichtung, repräsentiert. Unbekannt sind bislang B, I und r.

Anders ausgedrückt zeigt Fig. 1 eine Darstellung der Magnetfeldkomponente B parallel zur Wandebene der Wand 105 für einen stromdurchflossenen Leiter in Form der Leitung 100.

Fig. 2 zeigt eine schematische Darstellung einer Sensorvorrichtung 200 gemäß einem nicht erfindungsgemäßen Beispiel.

Die Sensorvorrichtung 200 weist zumindest ein Sensorelement 205 und eine Auflagefläche 210 auf. Lediglich beispielhaft weist die Sensorvorrichtung 200 gemäß diesem Beispiel eine Mehrzahl von Sensorelementen 205, in diesem Fall beispielhaft 112 Sensorelemente 205 auf.

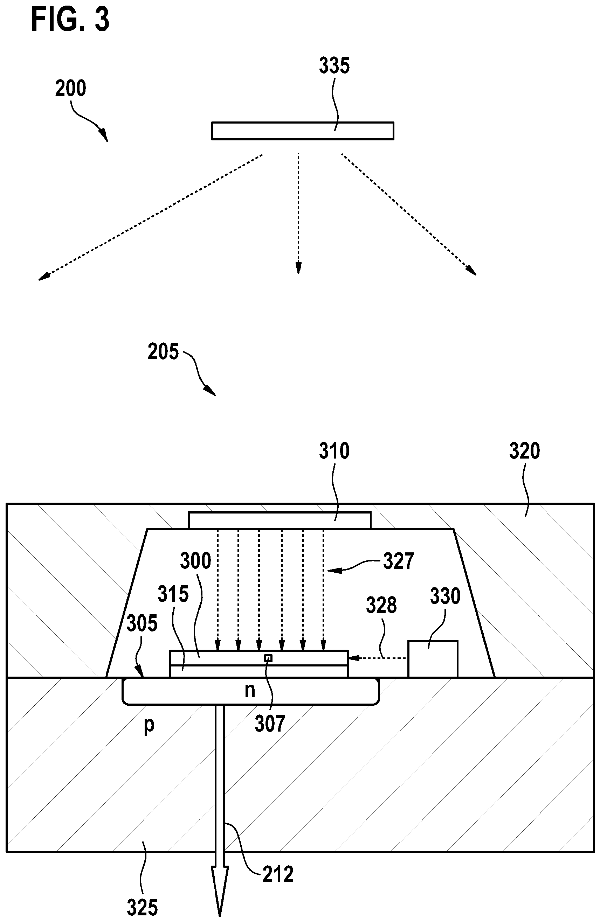

Jedes der Sensorelemente 205 ist ausgebildet, um ein von einer stromdurchflossenen Leitung hervorgerufenes Magnetfeld zu detektieren und ein das Magnetfeld repräsentierende Detektionssignal 212 bereitzustellen. Dieser Vorgang ist anhand von Fig. 3 genauer beschrieben. Bei der Leitung kann es sich um die anhand von Fig. 1 beschriebene Leitung handeln. Durch den in Fig. 2 gezeigten Pfeil ist eine der Anzahl von Sensorelementen 205 entsprechende Zahl von Detektionssignalen 212 angedeutet. Umso mehr Sensorelemente 205 und damit Detektionssignale 212 zur Verfügung stehen, umso schneller und genauer kann die Leitung detektiert werden.

Die Auflagefläche 210 ist dazu ausgebildet, um die Sensorvorrichtung 200 auf eine Fläche, beispielsweise auf die anhand von Fig. 1 beschriebene Wand, aufzulegen. Gemäß diesem Beispiel ist eine gesamte dargestellte Vorderseite 215 der Sensorvorrichtung 200 als die Auflagefläche 210 ausgeformt. Die Sensorelemente 205 sind in einer Ebene, hier matrixartig in einem Sensorfeld angeordnet, das sich über annähernd die gesamte Auflagefläche 210 erstreckt.

Gemäß diesem Beispiel weist die Sensorvorrichtung 200 eine optionale Auswerteeinrichtung 220 und eine optionale Anzeigeeinrichtung 225 auf. Die Auswerteeinrichtung 220 ist dazu ausgebildet, um für jedes der Sensorelemente 205 einen Wert des Magnetfelds an der Position des jeweiligen Sensorelementes 205 zu bestimmen unter Verwendung des von dem jeweiligen Sensorelements bereitgestellten Detektionssignals 212. Auf diese Weise ist die Auswerteeinrichtung 220 dazu ausgebildet, um eine der Anzahl von Sensorelementen entsprechende Anzahl von das Magnetfeld repräsentierenden Werten zu bestimmen, wodurch ein Verlauf des Magnetfelds und damit ein Verlauf der Leitung sehr genau bestimmt werden kann.

Gemäß diesem Beispiel ist die Auswerteeinrichtung 220 ferner dazu ausgebildet ist, um ein Bildsignal 235 zur bildlichen Darstellung 240 der elektrischen Leitung unter Verwendung de Werte des Magnetfelds zu bestimmen.

Die Anzeigeeinrichtung 225 ist gemäß diesem Beispiel mit der Auswerteeinrichtung 220 gekoppelt, wobei die Anzeigeeinrichtung 225 dazu ausgebildet ist, um unter Verwendung des Bildsignals 235 die bildliche Darstellung 240 der Leitung anzuzeigen. Gemäß diesem Beispiel ist auch eine weitere Darstellung 245 einer weiteren Leitung angezeigt, die ebenfalls von der Sensorvorrichtung 200 detektiert wird.

Anhand von Fig. 2 werden im Folgenden bereits beschriebene Details noch einmal genauer ausgeführt.

Die Sensorvorrichtung 200 kann auch als zweidimensionales Sensorfeld, auch Sensorarray genannt, zur Erstellung eines zweidimensionalen Bildes in Form der Darstellung 240, 245 von unzugänglichen elektrischen Leitungen bezeichnet werden.

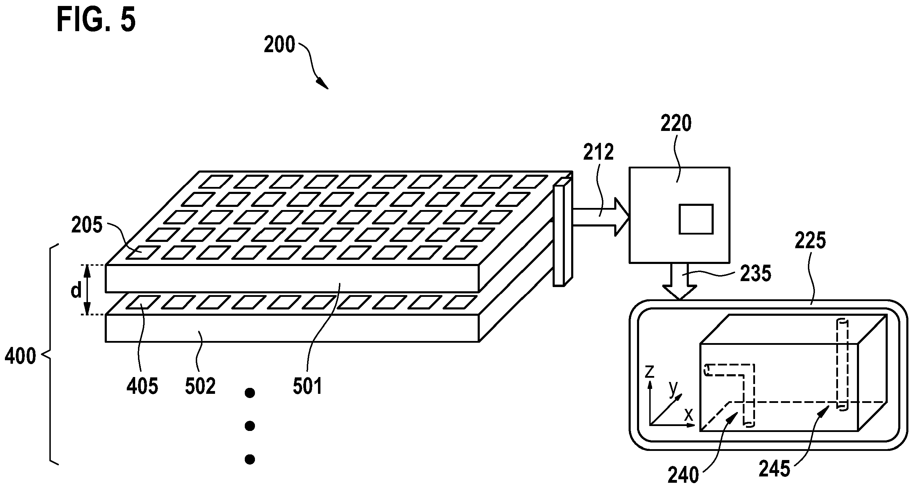

Der beschriebene Ansatz zur Lokalisierung des Stroms und zur Messung der Stromstärke des Stroms von unzugänglichen Leitungen beruht gemäß diesem Beispiel auf einem Array, also einem Feld aus einer Mehrzahl, von einzelnen Sensorelementen 205, die jeweils eine Diamantschicht mit zumindest einem Stickstoff-Vakanz-Zentrum, auch NV-Zentren genannt, aufweisen. Die Sensorvorrichtung 200 mit miniaturisierten Stickstoff-Vakanz-Zentrum-Sensorelementen 205 wird im Betrieb der Sensorvorrichtung 200 direkt an die Wand oder ein Objekt gehalten, in der oder dem die stromdurchflossenen Leitungen detektiert werden sollen. Bei Verwendung eines zweidimensionalen Sensorarrays, wie es in Fig. 2 gezeigt ist, wird zunächst über ein Display in Form der Anzeigeeinrichtung 225 eine zweidimensionale Projektion, also die Darstellungen 240, 245 von den hinter der Sensorvorrichtung 200 liegenden stromdurchflossenen Leitungen bereitgestellt. Durch eine definierte Verschiebung der Sensorvorrichtung 200 senkrecht zur Wand bzw. durch Verwenden einer anhand von Fig. 5 beschriebenen dreidimensionalen Sensorvorrichtung 200 kann zudem eine dreidimensionale Darstellung 240, 245 der stromdurchflossenen Leitungen und den darin fließenden Strömen erzeugt werden. So ist eine Leitungs-Tomografie darstellbar.

Fig. 3 zeigt einen Querschnitt eines Sensorelements 205 einer Sensorvorrichtung 200 gemäß einem Ausführungsbeispiel. Dabei kann es sich um eines der anhand von Fig. 2 beschriebenen Sensorelemente 205 handeln. Das Sensorelement 205 zum Detektieren von zumindest einer elektrischen Leitung weist eine Diamantschicht 300 und eine Detektionseinrichtung 305 auf. Die Diamantschicht 300 weist zumindest ein Stickstoff-Vakanz-Zentrum 307, typischerweise eine Mehrzahl von Stickstoff-Vakanz-Zentren 307 auf, wobei eine Fluoreszenzeigenschaft der Diamantschicht 300 abhängig von einem auf die Diamantschicht wirkenden Magnetfeld ist, das gemäß diesem Ausführungsbeispiel von einem durch die elektrische Leitung fließenden Strom hervorgerufen wird.

Die Detektionseinrichtung 305 ist dazu ausgebildet, um eine Fluoreszenz der Diamantschicht 300 zu detektieren und das die Fluoreszenz repräsentierende Detektionssignal 212 bereitzustellen. Gemäß diesem Ausführungsbeispiel ist die Detektionseinrichtung 305 als eine Silizium-Photodiode ausgeformt. Das Detektionssignal 212 kann von der anhand von Fig. 2 beschriebenen Auswerteeinrichtung ausgewertet werden, um den ersten Wert des Magnetfelds zu bestimmen.

Gemäß unterschiedlichen Ausführungsbeispielen weist das Sensorelement 205 eine optionale Bestrahlungseinrichtung 310, eine optionale Filtereinrichtung 315, ein Gehäuse 320 und einen Träger 325 auf.

Die Bestrahlungseinrichtung 310 ist dazu ausgebildet, um die Diamantschicht 300 mit einer elektromagnetischen Strahlung 327 zu bestahlen. Gemäß diesem Ausführungsbeispiel weist die Bestrahlungseinrichtung 310 einen LED-Chip auf, der Licht als die elektromagnetische Strahlung 327 aussendet. Die Bestrahlungseinrichtung 310 kann gemäß einem alternativen Ausführungsbeispiel auch alternativ oder zusätzlich einen VCSEL-Laserchip (Oberflächenemitter-Laserchip) umfassen. Gemäß diesem Ausführungsbeispiel ist zusätzlich oder alternativ eine weitere Bestrahlungseinrichtung in Form einer Antenne 330 vorgesehen, die dazu ausgebildet ist, um Mikrowellenstrahlung als weitere elektromagnetische Strahlung 328 auszusenden.

Gemäß einem Ausführungsbeispiel ist der Träger 325 ein Siliziumsubstrat und die Detektionseinrichtung 305 ist als eine pn-Fotodiode mit einem n-dotierten Bereich (n-Si) und einem p-dotierten Bereich (p-Si) ausgeführt. Das Gehäuse 320 ist gemäß einem Ausführungsbeispiel als ein die Bestrahlungseinrichtung 310 in Form einer LED-Struktur umfassender LED-Wafer ausgeführt.

Die Filtereinrichtung 315 ist dazu ausgebildet, um einen Anteil der elektromagnetischen Strahlung 327, 328, der die Diamantschicht 300 durchdrungen hat, auszufiltern. Andererseits ist die Filtereinrichtung 315 dazu ausgebildet, um durch die Fluoreszenz bewirkte Strahlung passieren zu lassen, damit die durch die Fluoreszenz bewirkte Strahlung von der Detektionseinrichtung 305 detektiert werden kann. Gemäß diesem Ausführungsbeispiel ist die Filtereinrichtung 315 zwischen der Diamantschicht 300 und der Detektionseinrichtung 305 angeordnet, um die von der Diamantschicht 300 ausgehende Strahlung zu filtern, bevor sie auf die Detektionseinrichtung 305 trifft.

Anhand von Fig. 3 werden im Folgenden bereits beschriebene Details anhand eines Ausführungsbeispiels noch einmal genauer ausgeführt.

Dargestellt ist ein monolithisch integriertes Sensorelement 205. Die Bestrahlungseinrichtung 310 stellt eine Lichtquelle in Form eines LED-Laserchips dar, der auf eine Si-Photodiode 305 gebondet ist. Auf der Photodiode 305 befindet sich ein optischer Filter 315 zur Filterung des Anregungslichts 327, darauf angeordnet ist die mit einem Stickstoff-Vakanz-Zentrum 307 versetzte Diamantschicht 300. Am Rand der Photodiode 305 befindet sich eine RF-Streifenantenne 330 zur Einkopplung der Mikrowellenstrahlung 328.

Stickstoff-Vakanz-Zentren 307 reagieren extrem sensitiv auf externe Magnetfelder und zeigen dies durch eine Aufspaltung ihrer quantisierten Zustände im Diamantkristall in Form der Diamantschicht 300 basierend auf dem Zeeman-Effekt. Diese Aufspaltung reagiert linear auf Magnetfeldänderung über einen Magnetfeldstärkenbereich von nT bis zu 1000 T. Eine stromdurchflossene Leitung bildet durch Induktion ein Magnetfeld aus, welches durch ein in der Nähe befindliches Stickstoff-Vakanz-Zentrum 307 detektiert werden kann. Ist ein Abstand zwischen der Leitung und dem Stickstoff-Vakanz-Zentrum 307 bekannt, kann das Magnetfeld bestimmt werden und damit die in der Leitung fließende Stromstärke.

In der Diamantschicht 300 kann mit Hilfe von optischer und Mikrowellen-Anregung 327, 328 und Detektion der ausgesendeten Floreszenz ein externes Magnetfeld detektiert werden. Wird die detektierte Fluoreszenz in Abhängigkeit von der Mikrowelleneinstrahlung aufgetragen, so ergibt sich bei Vorhandensein eines Magnetfeldes eine Frequenzaufspaltung, auch Zeeman-Splitting genannt, des Fluoreszenzminimums, die sich proportional mit wachsendem Magnetfeld vergrößert. Die Aufspaltung ist von der Ausrichtung des Magnetfeldes bezüglich der Achse des Stickstoff-Vakanz-Zentrums 307 in der Diamantschicht 300 abhängig. Da es insgesamt vier verschiedene Möglichkeiten für das Stickstoff-Vakanz-Zentrum 307 gibt, sich in der Diamantschicht 300 anzuordnen, gibt es bei verschieden ausgerichteten Stickstoff-Vakanz-Zentren 307 bis zu vier Paare von Frequenzaufspaltungen, aus deren Lage und Form der Betrag und die Richtung des Magnetfeldes bestimmbar sind.

Eine in der Nähe des Stickstoff-Vakanz-Zentrums 307 liegende mit einer Stromstärke durchflossene Leitung verursacht im Abstand aufgrund von Induktion ein radiales Magnetfeld.Dadurch kann ein stromdurchflossener Leiter mithilfe des Stickstoff-Vakanz-Zentrums 307 detektiert werden. Ist zudem der Abstand zwischen dem Stickstoff-Vakanz-Zentrum 307 und der Leitung bekannt, kann die Stromstärke anhand der anhand von Fig. 1 beschriebenen Formel ermittelt werden.

Bei einer mehrere Sensorelemente 205 umfassenden Sensorvorrichtung 200 ist es in einem alternativen Ausführungsbeispiel auch möglich, anstelle von in den Sensorelementen 205 integrierter Antennen 330 nur eine gemeinsame Bestrahlungseinrichtung 335, beispielsweise in Form einer Mikrowellenquelle zu verwenden. Hierbei kann nur eine einzige große Antenne verwendet werden, die zur gleichzeitigen Anregung aller Sensorelemente 205 der Sensorvorrichtung 200 verwendet werden kann. Zusätzlich oder alternativ kann die optische Anregung unter Verwendung der oder einer weiteren gemeinsamen Bestrahlungseinrichtung 335 aufgesplittet sein, sodass innerhalb der Sensorelemente 205 keine Bestrahlungseinrichtungen 310 erforderlich sind. Hierzu kann ein leistungsstarker Laser durch die Verwendung von zum Beispiel einem Glasfaserbündel aufgeteilt und dann zu den einzelnen Sensorelementen 205 geführt werden. Jedes Sensorelement 205 reagiert auf ein mögliches externes Magnetfeld und kann durch die Verwendung einer elektronischen Auswerteelektronik in Form der anhand von Fig. 2 beschriebenen Auswerteeinrichtung den Betrag und die Richtung des Magnetfelds am Ort des Sensorelements 205 bestimmen. Die Magnetfeldkomponente parallel zur Wand erreicht dann ihren maximalen Betrag, wenn die Leitung direkt unter dem Sensorelement 205 liegt. Dadurch kann das Vorhandensein von stromdurchflossenen Leitungen detektiert werden. Eine mit der Sensorvorrichtung verbundene Anzeigeeinrichtung kann dann nach der Signalverarbeitung des Detektionssignals die zweidimensionale Darstellung der stromdurchflossenen Leitung anzeigen. Dargestellt wird dabei eine Magnetfeldstärke in Abhängigkeit von der jeweiligen Lage des einzelnen Sensorelements 205. Aufgrund des bislang unbekannten Abstandes zwischen der Leitung und dem Sensorelement 205 kann nur das Verhältnis zwischen Stromstärke und Radius bestimmt werden.

In einem alternativen Ausführungsbeispiel kann durch das Einbringen eines definierten Signals in die Leitung das Auffinden der Leitung vereinfacht werden.

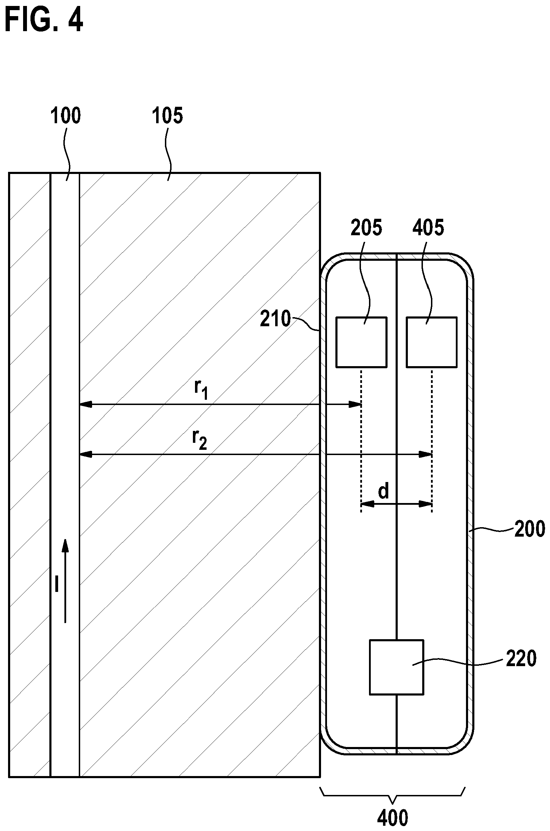

Fig. 4 zeigt einen Querschnitt einer Sensorvorrichtung 200 gemäß einem Ausführungsbeispiel, die an der anhand von Fig. 1 beschriebenen Wand 105 angelegt ist, um den Leiter 100 zu detektieren. Die Sensorvorrichtung 200 umfasst ein Sensorfeld 400 aus einem Sensorelement 205 und einem weiteren Sensorelement 405, die vertikal zu der Auflagefläche 210 übereinandergestapelt angeordnet sind.

Die Auflagefläche 210 der Sensorvorrichtung 200 ist gemäß diesem Ausführungsbeispiel auf die Wand 105 aufgelegt. Ein Abstand zwischen dem Leiter 100 und dem Sensorelement 205 wird mit $r_1$ und ein Abstand zwischen dem Leiter 100 und dem weiteren Sensorelement

405 wird mit $r_2$ angenommen. Ein Abstand zwischen den Sensorelementen 205, 405 wird mit d bezeichnet. Aus Fig. 4 ist eine schematische Darstellung der Funktionsweise der Abstands- und Stromstärkenbestimmung ersichtlich. Die beiden Sensorelemente 205, 405, deren Abstand d zueinander bekannt ist, detektieren jeweils ein Stromstärken-Radius-Verhältnis (I-r-Verhältnis), wodurch die Stromstärke I durch den Leiter sowie die Tiefe in Form des Radius $r_1$ des Leiters in der Wand von der Auswerteeinrichtung 220 bestimmt werden kann. Die dazu erforderliche Verarbeitung der von den Sensorelementen 205, 405 bereitgestellten Detektionssignalen wird gemäß einem Ausführungsbeispiel von einer Auswertevorrichtung 200 ausgeführt.

Gemäß einem alternativen Ausführungsbeispiel kann das Sensorfeld 400 neben dem gezeigten Stapel aus den Sensorelementen 205, 405 weitere Stapel aus Sensorelementen umfassen, wie es in Fig. 5 gezeigt ist.

Fig. 5 zeigt eine perspektivische Darstellung einer Sensorvorrichtung 200 gemäß einem Ausführungsbeispiel. Dabei kann es sich um die anhand von Fig. 2 beschriebene Sensorvorrichtung 200 handeln, mit dem Unterschied, dass gemäß diesem Ausführungsbeispiel zwei übereinandergestapelte Sensorfelder 501, 502 vorgesehen sind. Das erste Sensorfeld 501 weist eine Mehrzahl von Sensorelementen 205 und das zweite Sensorfeld 502 eine Mehrzahl von Sensorelementen 405 auf, von denen jeweils nur eines mit einem Bezugszeichen versehen ist. Durch die zwei übereinanderliegend angeordneten Sensorfelder 501, 502 entsteht eine Mehrzahl von den anhand von Fig. 4 beschriebenen Stapeln, wodurch sich auch durch ein hier dargestelltes Ausführungsbeispiel die Stromstärke, wie anhand von Fig. 4 erklärt, berechnen lässt. Gemäß diesem Ausführungsbeispiel ist die Auswerteeinheit 220 dazu ausgebildet, um unter Verwendung der Detektionssignale 212 der Sensorelemente 205, 405 der Sensorfelder 501, 502 stromdurchflossene Leitungen in einem Sensierbereich der Sensorvorrichtung 200 zu detektieren. Zum Empfangen der Detektionssignale 212 ist die Auswerteeinheit 220 gemäß einem Ausführungsbeispiel mit jedem der Sensorelemente 205, 405 über eine elektrische Leiterbahn verbunden.

Gemäß diesem Ausführungsbeispiel ist die Auswerteeinrichtung 220 dazu ausgebildet, um ein Bildsignal 235 zur bildlichen Darstellung 240, 245 sensierter elektrischer Leitungen unter Verwendung der Detektionssignale 212 zu bestimmen. Das Bildsignal 235 repräsentiert gemäß diesem Ausführungsbeispiel eine dreidimensionale Darstellung 240, 245 zweier Leitungen.

Im Folgenden werden bereits beschriebene Details anhand von Fig. 5 noch einmal genauer ausgeführt.

Die in Fig. 5 gezeigte Sensorvorrichtung 200 kann auch als eine Messvorrichtung zur Erstellung einer Leitungstomografie durch ein dreidimensionales Sensorarray 400 bestehend aus zumindest zwei Sensorfeldern 501, 502 bezeichnet werden. Die zweidimensionalen Sensorfelder 501, 502 weisen einen definierten Abstand d zueinander auf.

Um den Abstand zwischen der Sensorvorrichtung 200 und dem zu detektierenden Leiter und dessen Stromstärke bestimmen zu können, wird ein dreidimensionales Sensorarray 400 eingesetzt. Gemäß diesem Ausführungsbeispiel werden dazu ein oder mehrere weitere Sensorfelder 502 von Sensorelementen 405 hinter dem bereits anhand von Fig. 2 bestehenden Sensorfeld angeordnet. Die hintereinanderliegenden Paare von Sensorelementen 205, 405 der Sensorfelder 501, 502 können durch den Vergleich ihrer gemessenen Strom-zu-Abstand-Verhältnisse und dem bekannten Abstand d zwischen den Sensorelementen 205, 405, die Tiefe des Leiters in der Wand sowie die Stromstärke im Leiter bestimmen, wie es anhand der obigen genannten Gleichung bereits beschrieben ist.

Gemäß einem Ausführungsbeispiel ist eine angeschlossene Anzeigeeinrichtung 225 vorgesehen, die ausgebildet ist, um ein dreidimensionales Bild 240, 245 (Tomografie) der in der Wand liegenden Leiter liefern. Insbesondere erfolgt eine Darstellung der Stromstärke in Abhängigkeit der Lage im zweidimensionalen Array (x-y-Ebene) und des berechneten Abstandes zum Leiter.

Die anhand von Fig. 4 beschriebene Sensorvorrichtung 200 kann ebenso das hier beschriebene Bildsignal 235 zur dreidimensionalen Darstellung 240, 245 der Leitungen bestimmen.

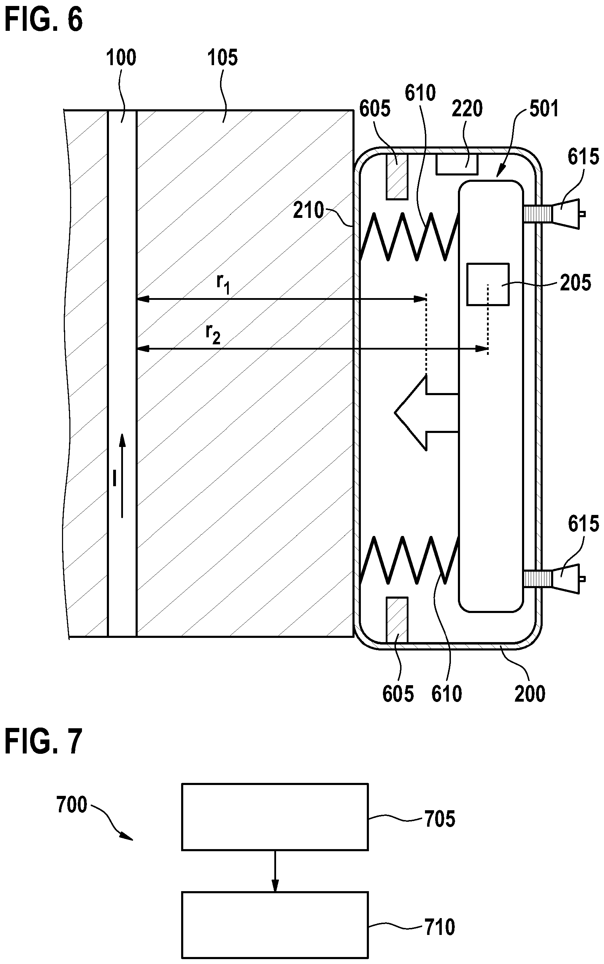

Fig. 6 zeigt einen Querschnitt einer Sensorrichtung 200 gemäß einem Ausführungsbeispiel. Im Unterschied zu der anhand von Fig. 4 beschriebene Sensorvorrichtung weist die anhand von Fig. 6 beschriebenen Sensorvorrichtung 200 keine übereinandergestapelten Sensorelemente sondern nur ein Sensorfeld 501 mit zumindest einem Sensorelement 205 auf. Um dennoch unterschiedliche Abstände $r_1$, $r_2$ zu dem Leiter 100 zu erreichen, weist die Sensorvorrichtung 200 eine Einstelleinrichtung auf, die dazu ausgebildet, um einen vertikalen Abstand des Sensorfelds 501 und damit des zumindest einen Sensorelements 205 zu der Auflagefläche 210 einzustellen. Hierzu weist die Einstelleinrichtung geeignete Mittel, gemäß diesem Ausführungsbeispiel beispielsweise zwei Abstandshalter 605, zwei Federn 610 und zwei Mikrometerschrauben 615 auf. Unter Verwendung der Mikrometerschrauben 615 kann das Sensorfeld 501 entgegen der Rückstellkraft der Federn 610 in Richtung der Auflagefläche 210 bewegt werden. Durch die Abstandshalter 605 kann das Einhalten eines Mindestabstands oder auch der definierte Abstand $r_1$ zwischen der Auflagefläche 210 und dem Sensorfeld 501 sichergestellt werden. Der weitere definierte Abstand $r_2$ kann beispielsweise durch ein maximal mögliches Herausdrehen der Mikrometerschrauben 615 erreicht werden.

Durch die Einstelleinrichtung ist eine definierte Abstandsänderung des Abstands des Sensorelements 205 zu der Auflagefläche 210 möglich. Die Abstandsänderung repräsentiert hierbei einen bekannten Abstand: $r_2$-$r_1$. Nach Einstellung der beiden Abstände $r_2$-$r_1$ kann

jeweils eine Messung durchgeführt werden. Geht man davon aus, dass sich die Stromstärke I in der Leitung 100 zwischen den beiden Messungen nicht ändert, dann können durch den Vergleich der beiden Messungen der Abstand sowie die Stromstärke I extrahiert werden. Die definierte Abstandsänderung des Sensorelements 205 zu der Auflagefläche 210 ist durch eine Mikrometerjustageeinheit in Form der Mikrometerschrauben 615 ausführbar.

Gemäß einem alternativen Ausführungsbeispiel weist die Sensorvorrichtung 200 keine Einstelleinrichtung, sondern zumindest eine Sensoreinrichtung auf, die ausgebildet ist, um eine Beschleunigung und/oder eine Rotation der Sensorvorrichtung 200 zu erfassen und zumindest ein die Beschleunigung und/oder die Rotation repräsentierendes Änderungssignal auszugeben. In diesem Fall ist die Auswerteeinrichtung 220 dazu ausgebildet, um dem ersten Wert des Magnetfelds unter Verwendung des Änderungssignals einen Positionswert zuzuordnen. Zum Erfassen der Rotation kann die Sensoreinrichtung beispielsweise eine Drehsensoreinrichtung oder eine Bestimmungseinrichtung zum Bestimmen der Rotation unter Verwendung von Erdmagnetfeldmessungen umfassen. Die Drehsensoreinrichtung kann dabei als separate Einrichtung ausgeführt sein oder einer Beschleunigungssensoreinrichtung kombiniert sein.

Bei diesem Ausführungsbeispiel des Ansatzes kann ein einzelnes Sensorelement 205 mit der Beschleunigungssensoreinrichtung in Form eines Beschleunigungs- und Drehratensensors kombiniert sein. Durch Bewegen der Sensorvorrichtung 200 vor der Wand 105 in alle drei Raumrichtungen und Messen dieser Bewegung durch Inertialsensoren wie den Beschleunigungs- und den Drehratensensor kann dann durch die Anzeigeeinrichtung auch ein 3D-Leitungsbild in Form der anhand einer der vorangegangenen Figuren beschriebenen Darstellung der Leitung/en erstellt werden.

Fig. 7 zeigt ein Ablaufdiagramm eines Verfahrens 700 zum Detektieren einer elektrischen Leitung. Dabei kann es sich um ein Verfahren 700 handeln, das von einem der anhand der vorangegangenen Figuren beschriebenen Sensorelemente ausführbar ist.

Das Verfahren 700 ist dazu ausgebildet, um unter Verwendung einer Diamantschicht mit zumindest einem Stickstoff-Vakanz-Zentrum zumindest eine elektrische Leitung zu detektieren. Eine Fluoreszenzeigenschaft der Diamantschicht ist dabei abhängig von einem durch einen durch die elektrische Leitung fließenden Strom hervorgerufenen Magnetfeld. In einem Schritt 705 des Detektierens wird eine Fluoreszenz der Diamantschicht detektiert. In einem Schritt 710 des Bereitstellens wird ein die Fluoreszenz repräsentierendes Detektionssignal bereitgestellt.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Sensorvorrichtung (200) zum Detektieren einer elektrischen Leitung (100), wobei die Sensorvorrichtung (200) eine Auflagefläche (210) zum Auflegen der Sensorvorrichtung (200) auf eine Fläche und zumindest ein benachbart zu der Auflagefläche (210) angeordnetes Sensorelement (205), das

   eine Diamantschicht (300) mit zumindest einem Stickstoff-Vakanz-Zentrum (307) umfasst, wobei eine Fluoreszenzeigenschaft der Diamantschicht (300) abhängig von einem durch einen durch die elektrische Leitung (100) fließenden Strom hervorrufbaren Magnetfeld (B) ist, und eine Detektionseinrichtung (305) zum Detektieren einer Fluoreszenz der Diamantschicht (300) und zum Bereitstellen eines von der Fluoreszenz abhängigen Detektionssignals (212) umfasst, **dadurch gekennzeichnet, dass** die Sensorvorrichtung (200) zumindest einen Stapel (400) aus zumindest zwei der genannten Sensorelementen (205; 405) aufweist, die im Wesentlichen vertikal zu der Auflagefläche (210) benachbart zueinander angeordnet sind und/oder eine Einstelleinrichtung (610, 615) aufweist, die ausgebildet ist, um einen vertikalen Abstand des Sensorelements (205) zu der Auflagefläche (210) einzustellen.

2. Sensorvorrichtung (200) gemäß Anspruch 1, bei der das Sensorelement (205) eine Bestrahlungseinrichtung (310, 330) zum Bestrahlen der Diamantschicht (300) mit einer elektromagnetischen Strahlung (327, 330) aufweist.

3. Sensorvorrichtung (200) gemäß Anspruch 2, bei der die Bestrahlungseinrichtung (330) ausgebildet ist, um Mikrowellenstrahlung (328) als die elektromagnetische Strahlung auszusenden.

4. Sensorvorrichtung (200) gemäß einem der Ansprüche 2 bis 3 bei der die Bestrahlungseinrichtung (310) ausgebildet ist, um Licht als die elektromagnetische Strahlung (327) auszusenden.

5. Sensorvorrichtung (200) gemäß einem der Ansprüche 2 bis 4 bei der das Sensorelement (205) eine Filtereinrichtung (315) zum Ausfiltern eines die Diamantschicht (300) durchdringenden Anteils der elektromagnetischen Strahlung aufweist.

6. Sensorvorrichtung (200) gemäß einem der vorangegangenen Ansprüche, mit einem Feld (501) aus einer Mehrzahl von nebeneinander und benachbart zu der Auflagefläche (210) angeordneten Sensorelementen (205).

7. Sensorvorrichtung (200) gemäß einem der vorangegangenen Ansprüche, mit einer gemeinsamen Bestrahlungseinrichtung (335) zum gemeinsamen Bestrahlen der Diamantschichten (300) der Mehrzahl von Sensorelementen (205; 405) mit einer elektromagnetischen Strahlung.

8. Sensorvorrichtung (200) gemäß einem der vorangegangenen Ansprüche, mit einer Auswerteeinrichtung (220), die dazu ausgebildet ist, um einen Wert des Magnetfelds (B) im Bereich des zumindest einen Sensorelements (205) unter Verwendung des Detektionssignals (212) des zumindest einen Sensorelements (205) zu bestimmen.

9. Sensorvorrichtung (200) gemäß Anspruch 8, bei der die Auswerteeinrichtung (220) dazu ausgebildet ist, um ein Bildsignal (235) zur bildlichen Darstellung (240) der elektrischen Leitung (100) unter Verwendung des Werts des Magnetfelds (B) zu bestimmen.

10. Sensorvorrichtung (200) gemäß einem der vorangegangenen Ansprüche, bei der die Auswerteeinrichtung (220) dazu ausgebildet ist, um einen weiteren Wert des Magnetfelds (B) an dem Sensorelement (205) oder an einem weiteren Sensorelement (405) unter Verwendung eines weiteren Detektionssignals (212) des Sensorelements (205) oder des weiteren Sensorelements (405) zu bestimmen, und dazu ausgebildet ist, um unter Verwendung des Werts und des weiteren Werts einen Abstand der elektrischen Leitung (100) zu der Sensorvorrichtung (200) und/oder eine Stromstärke (I) des durch die elektrische Leitung (100) fließenden Stroms zu bestimmen.

11. Sensorvorrichtung (200) gemäß einem der vorangegangenen Ansprüche, mit einer Beschleunigungssensoreinrichtung, die ausgebildet ist, um eine Beschleunigung der Sensorvorrichtung (200) zu erfassen und ein die Beschleunigung repräsentierendes Beschleunigungssignal auszugeben und/oder mit einer Drehratensensoreinrichtung, die ausgebildet ist, um eine Rotation der Sensorvorrichtung zu erfassen und ein die Rotation repräsentierendes Rotationssignal auszugeben und/oder mit einer Bestimmungseinrichtung, die ausgebildet ist, um eine Winkelpositionsänderung der Sensorvorrichtung basierend auf Erdmagnetfeldmessungen zu erfassen und ein die Winkelpositionsänderung repräsentierendes Winkelpositionsänderungssignal auszugeben, und wobei die Auswerteeinrichtung (220), dazu ausgebildet ist, um dem Wert des Magnetfelds unter Verwendung des Beschleunigungssignals und/oder des Rotationssignals und/oder des Winkelpositionsänderungssignals einen Positionswert zuzuordnen.

## Claims

1. Sensor apparatus (200) for detecting an electric line (100), wherein the sensor apparatus (200) comprises a placement face (210) for placing the sensor apparatus (200) on a surface and at least one sensor element (205), which is arranged adjacent to the placement face (210) and comprises a diamond layer (300) with at least one nitrogen vacancy centre (307), wherein a fluorescence property of the diamond layer (300) is dependent on a magnetic field (B) that is able to be brought about by a current flowing through the electric line (100), and a detection device (305) for detecting fluorescence of the diamond layer (300) and for providing a detection signal (212) dependent on the fluorescence,
**characterized in that**
the sensor apparatus (200) has at least one stack (400) composed of at least two of the stated sensor elements (205; 405), which are arranged substantially vertically to the placement face (210) adjacent to one another, and/or has a setting device (610, 615), which is embodied to set a vertical distance of the sensor element (205) from the placement face (210).

2. Sensor apparatus (200) according to Claim 1, in which the sensor element (205) has an irradiation device (310, 330) for irradiating the diamond layer (300) with electromagnetic radiation (327, 330).

3. Sensor apparatus (200) according to Claim 2, in which the irradiation device (330) is embodied to emit microwave radiation (328) as the electromagnetic radiation.

4. Sensor apparatus (200) according to one of Claims 2 to 3, in which the irradiation device (310) is embodied to emit light as the electromagnetic radiation (327).

5. Sensor apparatus (200) according to one of Claims 2 to 4, in which the sensor element (205) has a filter device (315) for filtering out a component of the electromagnetic radiation penetrating the diamond layer (300) .

6. Sensor apparatus (200) according to one of the preceding claims, having a field (501) of a plurality of sensor elements (205), which are arranged next to one another and adjacent to the placement face (210).

**7.** Sensor apparatus (200) according to one of the preceding claims, having a common irradiation device (335) for jointly irradiating the diamond layers (300) of the plurality of sensor elements (205; 405) with electromagnetic radiation.

**8.** Sensor apparatus (200) according to one of the preceding claims, having an evaluation device (220), which is embodied to determine a value of the magnetic field (B) in the region of the at least one sensor element (205) by using the detection signal (212) of the at least one sensor element (205).

**9.** Sensor apparatus (200) according to Claim 8, in which the evaluation device (220) is embodied to determine an image signal (235) for presenting (240) an image of the electric line (100) by using the value of the magnetic field (B).

**10.** Sensor apparatus (200) according to one of the preceding claims, in which the evaluation device (220) is embodied to determine a further value of the magnetic field (B) at the sensor element (205) or at a further sensor element (405) by using a further detection signal (212) of the sensor element (205) or of the further sensor element (405) and is embodied to determine, by using the value and the further value, a distance of the electric line (100) from the sensor apparatus (200) and/or a current strength (I) of the current flowing through the electric line (100).

**11.** Sensor apparatus (200) according to one of the preceding claims, having an acceleration sensor device, which is embodied to capture the acceleration of the sensor apparatus (200) and to output an acceleration signal representing the acceleration, and/or having a rotation rate sensor device, which is embodied to capture a rotation of the sensor apparatus and to output a rotation signal representing the rotation, and/or having a determination device, which is embodied to capture an angular position change of the sensor apparatus based on measurements of Earth's magnetic field and to output an angular position change signal representing the angular position change, and wherein the evaluation device (220) is embodied to assign a position value to the value of the magnetic field by using the acceleration signal and/or the rotation signal and/or the angular position change signal.

**Revendications**

**1.** Dispositif formant capteur (200) destiné à détecter une ligne électrique (100), le dispositif formant capteur (200) comprenant une surface d'appui (210) qui permet au dispositif formant capteur (200) de venir en appui sur une surface et au moins un élément formant capteur (205) qui est disposé de manière adjacente à la surface d'appui (210) et qui comprend une couche de diamant (300) pourvue d'au moins un centre de vacance d'azote (307), une propriété de fluorescence de la couche de diamant (300) dépendant d'un champ magnétique (B) qui peut être produit par un courant circulant à travers la ligne électrique (100), et un moyen de détection (305) destiné à détecter une fluorescence de la couche de diamant (300) et à fournir l'un des signaux de détection dépendant de la fluorescence (212),
**caractérisé en ce que**
le dispositif formant capteur (200) comporte au moins un empilement (400) d'au moins deux desdits éléments formant capteurs (205 ; 405), qui sont disposés de manière adjacente l'un à l'autre sensiblement verticalement par rapport à la surface d'appui (210), et/ou un moyen de réglage (610, 615) qui est conçu pour régler une distance verticale entre l'élément formant capteur (205) et la surface d'appui (210).

**2.** Dispositif formant capteur (200) selon la revendication 1, dans lequel l'élément formant capteur (205) comporte un moyen d'irradiation (310, 330) destiné à irradier la couche de diamant (300) avec un rayonnement électromagnétique (327, 330).

**3.** Dispositif formant capteur (200) selon la revendication 2, dans lequel le moyen d'irradiation (330) est conçu pour émettre un rayonnement micro-ondes (328) comme rayonnement électromagnétique.

**4.** Dispositif formant capteur (200) selon l'une des revendications 2 à 3, dans lequel le moyen d'irradiation (310) est conçu pour émettre de la lumière comme rayonnement électromagnétique (327).

**5.** Dispositif formant capteur (200) selon l'une des revendications 2 à 4, dans lequel l'élément formant capteur (205) comporte un moyen de filtrage (315) destiné à filtrer une partie du rayonnement électromagnétique qui pénètre dans la couche de diamant (300) .

**6.** Dispositif formant capteur (200) selon l'une des revendications précédentes, lequel comporte une zone (501) comprenant une pluralité d'éléments formant capteurs (205) qui sont disposés les uns à côté des autres et de manière adjacente à la surface d'appui (210) .

**7.** Dispositif formant capteur (200) selon l'une des revendications précédentes, lequel comporte un moyen d'irradiation commun (335) destiné à irradier conjointement les couches de diamant (300) de la pluralité d'éléments formant capteurs (205 ; 405) avec un rayonnement électromagnétique.

8. Dispositif formant capteur (200) selon l'une des revendications précédentes, lequel comporte un moyen d'évaluation (220) qui est conçu pour déterminer une valeur du champ magnétique (B) dans la région de l'au moins un élément formant capteur (205) en utilisant le signal de détection (212) de l'au moins un élément formant capteur (205).

9. Dispositif formant capteur (200) selon la revendication 8, dans lequel le moyen d'évaluation (220) est conçu pour déterminer un signal d'image (235) destiné à représenter de manière imagée (240) la ligne électrique (100) en utilisant la valeur du champ magnétique (B).

10. Dispositif formant capteur (200) selon l'une des revendications précédentes, dans lequel le moyen d'évaluation (220) est conçu pour déterminer une autre valeur du champ magnétique (B) au niveau de l'élément formant capteur (205) ou d'un autre élément formant capteur (405) en utilisant un autre signal de détection (212) de l'élément formant capteur (205) ou de l'autre élément formant capteur (405) et est conçu pour déterminer une distance entre la ligne électrique (100) et le dispositif formant capteur (200) et/ou une intensité de courant (I) du courant circulant dans la ligne électrique (100) en utilisant la valeur et l'autre valeur.

11. Dispositif formant capteur (200) selon l'une des revendications précédentes, lequel comporte un moyen formant capteur d'accélération qui est conçu pour détecter une accélération du dispositif formant capteur (200) et pour délivrer un signal d'accélération représentant l'accélération et/ou comporte un moyen formant capteur de vitesse de rotation qui est conçu pour détecter la rotation du dispositif formant capteur et pour délivrer un signal de rotation représentant la rotation et/ou comporte un moyen de détermination qui est conçu pour détecter un changement de position angulaire du dispositif formant capteur sur la base de mesures du champ géomagnétique et pour délivrer un signal de changement de position angulaire représentant le changement de position angulaire, et le moyen d'évaluation (220) étant conçu pour associer une valeur de position à la valeur du champ magnétique en utilisant le signal d'accélération et/ou le signal de rotation et/ou le signal de changement de position angulaire.

# FIG. 1

EP 3 232 206 B1

FIG. 2

EP 3 232 206 B1

FIG. 3

14

# FIG. 4

FIG. 5

## FIG. 6

## FIG. 7

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 873706 B
- WO 2013188732 A1
- US 2015374250 A1